(19) Europäisches Patentamt
European Patent Office
Office européen des brevets

(11) **EP 4 622 144 A1**

(12) **EUROPEAN PATENT APPLICATION**
published in accordance with Art. 153(4) EPC

(43) Date of publication:
**24.09.2025 Bulletin 2025/39**

(21) Application number: **22967540.0**

(22) Date of filing: **06.12.2022**

(51) International Patent Classification (IPC):
**H04L 1/00** (2006.01)

(52) Cooperative Patent Classification (CPC):
**H04L 1/00**

(86) International application number:
**PCT/CN2022/137015**

(87) International publication number:
**WO 2024/119379 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Huawei Technologies Co., Ltd.**
**Shenzhen, Guangdong 518129 (CN)**

(72) Inventors:
• **TONG, Jiajie**
  **Shenzhen, Guangdong 518129 (CN)**

• **ZHANG, Huazi**
  **Shenzhen, Guangdong 518129 (CN)**
• **WANG, Xianbin**
  **Shenzhen, Guangdong 518129 (CN)**
• **WANG, Jun**
  **Shenzhen, Guangdong 518129 (CN)**

(74) Representative: **Goddar, Heinz J.**
**Boehmert & Boehmert**
**Anwaltspartnerschaft mbB**
**Pettenkoferstrasse 22**
**80336 München (DE)**

(54) **INFORMATION BIT DETERMINATION METHOD AND DEVICE**

(57) This application provides a method for determining an information bit and an apparatus, to improve communication performance when polar code rate matching is performed in a puncturing manner. The method includes: determining a first sequence based on a mother code length of a polar code and a length of a to-be-sent bit, wherein the mother code length is a positive integer power of 2, and the first sequence is for adjusting a reliability order of bits in the polar code; and determining a position of an information bit in the polar code based on the reliability order and the first sequence.

S101: Determine a first sequence based on a mother code length of a polar code and a length of a to-be-sent bit

↓

S102: Determine a position of an information bit in the polar code based on a reliability order and the first sequence

FIG. 5

**Description**

TECHNICAL FIELD

This application relates to the field of mobile communication technologies, and in particular, to a method for determining an information bit and an apparatus.

BACKGROUND

In a communication process based on polar (Polar) code encoding, if a code length for actual communication is different from a code length obtained after polar coding (that is, a mother code length), a code length matching process needs to be implemented in a manner of performing puncturing, retransmission, and the like on a bit sequence obtained by performing polar coding, and then code construction is performed based on a code length matching result. Specifically, an example of performing code length matching in a puncturing manner is used. First, it is determined, based on the code length for actual communication and the code length obtained after polar coding, to perform code length matching in the puncturing manner, and then a to-be-punctured position is determined. After the to-be-punctured bit position is determined, an information bit and a freezing bit are determined for code construction.

However, when code length matching is implemented in the puncturing manner, selection of an information bit in a polar code is affected, resulting in a performance bad point and communication performance deterioration.

SUMMARY

This application provides a method for determining an information bit and an apparatus, to improve communication performance when polar code rate matching is performed in a puncturing manner.

According to a first aspect, this application provides a method for determining an information bit, and the method may be implemented by a transmit end. The transmit end may be a terminal device, a network device, a component in the network device, or a component in the terminal device. The component in this application may include, for example, at least one of a chip, a chip system, a processor, a transceiver, a processing unit, or a transceiver unit. For example, an execution body is the transmit end. The method may be implemented through the following steps: The transmit end determines a first sequence based on a mother code length of a polar code and a length of a to-be-sent bit, where the mother code length is a positive integer power of 2, and the first sequence is for adjusting a reliability order of bits in the polar code; and the transmit end may further determine a position of an information bit in the polar code based on the reliability order and the first sequence.

Based on the method, the transmit end may determine the position of the information bit based on the reliability order and the first sequence. The position of the information bit is not determined based on the reliability order only. Instead, the position of the information bit is determined by adjusting the reliability order through the first sequence, so that a bad point can be avoided, and communication performance can be improved.

According to a second aspect, this application provides a method for determining an information bit, and the method may be implemented by a receive end. The receive end may be a terminal device, a network device, a component in the network device, or a component in the terminal device. The component in this application may include, for example, at least one of a chip, a chip system, a processor, a transceiver, a processing unit, or a transceiver unit. For example, an execution body is the receive end. The method may be implemented by using the following steps: The receive end receives first information, where the first information includes a mother code length of a polar code and a length of a to-be-sent bit, and the mother code length is a positive integer power of 2; the receive end may further determine a first sequence based on the mother code length of the polar code and the length of the to-be-sent bit, where the first sequence is for adjusting a reliability order of bits in the polar code; and the receive end may further determine a position of an information bit in the polar code based on the reliability order and the first sequence, and decode, based on the position of the information bit, data encoded by using the polar code.

In a possible implementation of the first aspect and the second aspect, the transmit end or the receive end may further obtain a first position value of a bit in the polar code, select an offset value from the first sequence based on the first position value, and determine a second position value of the bit in the polar code based on the offset value and the first position value, where the second position value is a position index of the information bit in the polar code.

Based on this implementation, the transmit end or the receive end may select the offset value from the first sequence based on the first position value of the polar code, accurately determine the second position value based on the offset value and the first position value, and determine the second position value as the position index of the information bit, thereby improving accuracy of determining the position of the information bit.

In a possible implementation of the first aspect and the second aspect, the transmit end or the receive end may further select an invalid value from the first sequence based on the first position value, and determine, based on the invalid value, not to solve the position index of the information bit in the polar code based on the first position value.

Based on this implementation, determining the position of the information bit based on the first position value corresponding to the invalid value may be ignored, thereby improving accuracy of determining the information bit.

In a possible implementation, the transmit end or the receive end may further determine, based on the first position value and a subblock length, a sequence number of a subblock to which the first position value belongs, and determine the offset value from a plurality of elements in the first sequence based on the sequence number.

Based on this implementation, the transmit end or the receive end may determine the sequence number of the subblock based on the subblock length and the first position value, and read the offset value based on the sequence number of the subblock, thereby improving accuracy of determining the offset value.

In a possible implementation, the second position value is determined based on the offset value, the first position value, and the subblock length.

Based on this implementation, accuracy of determining the second position value can be improved.

In a possible implementation, the transmit end or the receive end may further determine a pre-freezing position of the bit of the polar code based on the mother code length and the length of the to-be-sent bit, where the pre-freezing position is not used as the position of the information bit.

Based on this implementation, the pre-freezing position can be properly determined, and accuracy of determining the second position value is further improved.

In a possible implementation, if a code length E of the to-be-sent bit is not exactly divided by N/32, a quantity P of pre-freezing positions meets:

$$P = N - floor(E/(N/32))*(N/32),$$

or

if E is exactly divided by N/32, the quantity P of pre-freezing positions meets:

$$P = N - E + (N/32),$$

where

N represents the mother code length of the polar code, and floor() represents rounding down.

Based on this implementation, accuracy of determining the pre-freezing position can be further improved.

In a possible implementation, when $15.5*N/16 < E \leq N$, the first sequence is {0, 0, 0, 0, 0, 0, 0, 0, 0, 0, 0, 0, 0, 0, 0}, where N is the mother code length, and E is the length of the to-be-sent bit;

when $14.5*N/16 < E \leq 15.5*N/16$, the first sequence is {1, 1, NA, 0, 0, 0, 0, 0, 0, 0, 0, 0, 0, 0, 0}, where N is the mother code length, and E is the length of the to-be-sent bit;

when $13.5*N/16 < E \leq 14.5*N/16$, the first sequence is {NA, 1, 1, NA, 0, 0, 0, 0, 0, 0, 0, 0, 0, 0, 0}, where N is the mother code length, and E is the length of the to-be-sent bit;

when $12.5*N/16 < E \leq 13.5*N/16$, the first sequence is {NA, NA, 2, NA, -1, 0, 0, 0, 0, 0, 0, 0, 0, 0, 0}, where N is the mother code length, and E is the length of the to-be-sent bit;

when $11.5*N/16 < E \leq 12.5*N/16$, the first sequence is {NA, 3, NA, 2, NA, 1, NA, 0, 0, 0, 0, 0, 0, 0, 0}, where N is the mother code length, and E is the length of the to-be-sent bit;

when $10.5*N/16 < E \leq 11.5*N/16$, the first sequence is {NA, NA, NA, 3, 1, NA, 1, NA, 0, 0, 0, 0, 0, 0, 0}, where N is the mother code length, and E is the length of the to-be-sent bit;

when $9.5*N/16 < E \leq 10.5*N/16$, the first sequence is {NA, NA, NA, NA, 2, NA, 1, NA, 0, 0, 0, 0, 0, 0, 0}, where N is the mother code length, and E is the length of the to-be-sent bit; and

when $8*N/16 < E \leq 9.5*N/16$, the first sequence is {NA, NA, NA, 4, NA, NA, NA, NA, 0, 0, 0, 0, 0, 0, 0}, where N is the mother code length, and E is the length of the to-be-sent bit.

Based on this implementation, accuracy of the first sequence can be improved, and accuracy of determining the position of the information bit can be further improved.

According to a third aspect, a communication apparatus is provided. The apparatus may implement the method separately performed by the receive end or the transmit end in any possible implementation of the first aspect or the second aspect.

In an optional implementation, the apparatus may include modules that are in one-to-one correspondence with the methods/operations/steps/actions described in the first aspect or the second aspect and any possible implementation thereof. The module may be implemented by a hardware circuit, software, or a hardware circuit in combination with software. In an optional implementation, the apparatus includes a processing unit (sometimes also referred to as a processing module) and a communication unit (sometimes also referred to as a communication module, a transceiver module, or a transceiver unit). The communication unit can implement a sending function and a receiving function. When the communication unit implements the sending function, the communication unit may be referred to as a sending unit (sometimes also referred to as a sending module). When the communication unit implements the receiving function, the communication unit may be referred to as a receiving unit (sometimes also referred to as a receiving module). The sending unit and the receiving unit may be a same functional module, and the functional module can implement the sending function and the receiving function. Alternatively, the sending unit and the receiving unit may be different functional modules, and the transceiver unit is a collective name of these functional modules.

For another example, the apparatus includes a processor, coupled to a memory, and the processor is configured to execute instructions in the memory, to implement the method described in the first aspect or the second aspect and any possible implementation thereof. Optionally, the apparatus further includes another component, for example, an antenna, an input/output module, a transceiver, or a communication interface. Such components may be hardware, software, or a combination of software and hardware.

According to a fourth aspect, a computer-readable storage medium is provided. The computer-readable storage medium is configured to store a computer program or instructions, and when the computer program or the instructions are run, the method in any possible implementation of the first aspect or the second aspect is implemented.

According to a fifth aspect, a computer program product including instructions is provided. When the computer program product runs on a computer, the method in any possible implementation of the first aspect or the second aspect is implemented.

According to a sixth aspect, a chip system is provided. The chip system includes a logic circuit (which may alternatively be understood as that the chip system includes a processor, and the processor may include a logic circuit and the like), and may further include an input/output interface. The input/output interface may be configured to receive a message, or may be configured to send a message. The input/output interface may be a same interface. In other words, a same interface can implement both a sending function and a receiving function. Alternatively, the input/output interface includes an input interface and an output interface. The input interface is configured to implement a receiving function, that is, configured to receive a message. The output interface is configured to implement a sending function, that is, configured to send a message. The logic circuit may be configured to perform an operation other than the receiving/sending function of the first aspect or the second aspect and any possible implementation thereof. The logic circuit may be further configured to transmit a message to the input/output interface, or receive a message from another communication apparatus through the input/output interface. The chip system may be configured to implement the method in any possible implementation of the first aspect or the second aspect. The chip system may include a chip, or may include a chip and another discrete component.

Optionally, the chip system may further include a memory, and the memory may be configured to store instructions. The logic circuit may invoke the instructions stored in the memory to implement a corresponding function.

According to a seventh aspect, a communication system is provided. The communication system may include a transmit end and a receive end. The transmit end may be configured to perform the method in the first aspect and any possible implementation thereof. The receive end may be configured to perform the method in the second aspect and any possible implementation thereof.

For technical effects brought by the second aspect to the seventh aspect, refer to the descriptions of the first aspect. Details are not described herein again.

BRIEF DESCRIPTION OF DRAWINGS

FIG. 1 is a diagram of an architecture of a wireless communication system according to an embodiment of this application;
FIG. 2 is a diagram of an information bit and a frozen bit;
FIG. 3A is a diagram of a manner for determining an information bit according to an embodiment of this application;
FIG. 3B is a diagram of comparison between performance of transmission based on NAT puncturing, NR rate matching, and a solution of this application according to an embodiment of this application;
FIG. 3C is a diagram of comparison between performance of transmission based on subblock interleaving and a solution of this application according to an embodiment of this application;
FIG. 4 is a schematic flowchart of a polar code-based transmission;
FIG. 5 is a schematic flowchart of a method for determining a position of an information bit according to an embodiment of this application;
FIG. 6 is a diagram of a method for adjusting a reliability sequence Q based on a first sequence according to an embodiment of this application;

FIG. 7 is a diagram of a principle of adjusting a reliability sequence Q based on a first sequence according to an embodiment of this application;

FIG. 8 is a diagram of another principle of adjusting a reliability sequence Q based on a first sequence according to an embodiment of this application;

FIG. 9 is a schematic flowchart of a communication method according to an embodiment of this application;

FIG. 10 is a diagram of a structure of a communication apparatus according to an embodiment of this application;

FIG. 11 is a diagram of a structure of another communication apparatus according to an embodiment of this application; and

FIG. 12 is a diagram of a structure of another communication apparatus according to an embodiment of this application.

DESCRIPTION OF EMBODIMENTS

A method for determining an information bit provided in embodiments of this application may be applied to a 4th generation (4th generation, 4G) communication system, for example, a long term evolution (long term evolution, LTE) communication system, or may be applied to a 5th generation (5th generation, 5G) communication system, for example, a 5G new radio (new radio, NR) communication system, or may be applied to various future communication systems, for example, a 6th generation (6th generation, 6G) communication system. The method provided in embodiments of this application may be further applied to a Bluetooth system, a Wi-Fi system, a LoRa system, or an internet of vehicles system. The method provided in embodiments of this application may be further applied to a satellite communication system. The satellite communication system may be integrated with the foregoing communication system.

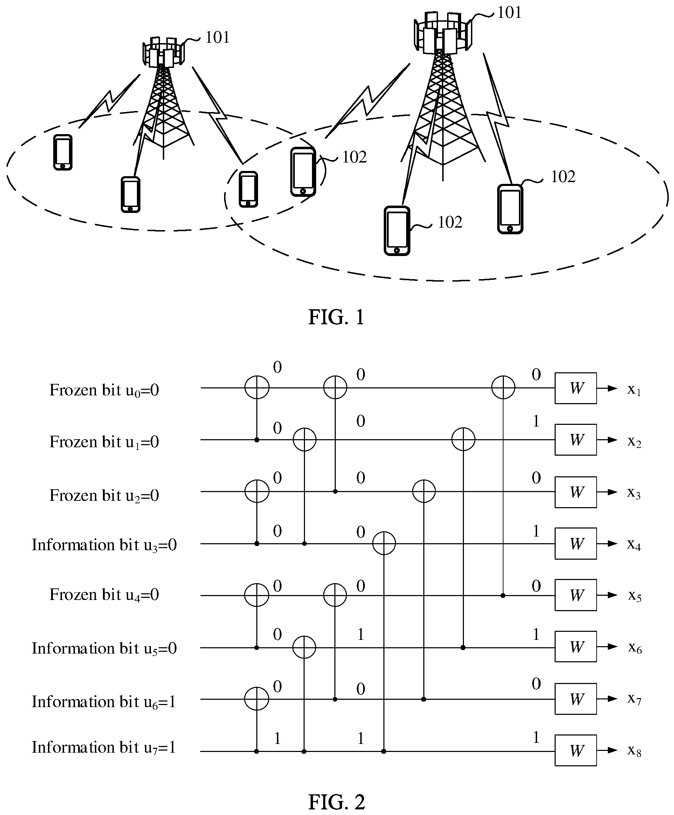

For ease of understanding embodiments of this application, an application scenario used in this application is described by using an architecture of a communication system shown in FIG. 1 as an example. As shown in FIG. 1, a communication system 100 includes a network device 101 and a terminal device 102. The apparatus provided in embodiments of this application may be applied to the network device 101 or the terminal device 102. It may be understood that FIG. 1 shows only one possible communication system architecture to which embodiments of this application may be applied. In another possible scenario, the communication system architecture may alternatively include another device.

The network device 101 is a node in a radio access network (radio access network, RAN), and may also be referred to as a base station or a RAN node (or device). Currently, some examples of the access network device 101 are: a gNB/NR-NB, a transmission reception point (transmission reception point, TRP), an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB or a home NodeB, HNB), a baseband unit (baseband unit, BBU), a wireless fidelity (wireless fidelity, Wi-Fi) access point (access point, AP), a satellite device, a network device in the 5G communication system, and a network device in a possible communication system in the future. Alternatively, the network device 101 may be another device having a network device function. For example, the network device 101 may alternatively be a device functioning as a network device in device to device (device to device, D2D) communication, internet of vehicles communication, or machine-communication. Alternatively, the network device 101 may be a network device in a possible future communication system.

In some deployments, the gNB may include a central unit (central unit, CU) and a DU. The gNB may further include a radio unit (radio unit, RU). The CU implements some functions of the gNB, and the DU implements some functions of the gNB. For example, the CU implements functions of a radio resource control (radio resource control, RRC) layer and a packet data convergence protocol (packet data convergence protocol, PDCP) layer, and the DU implements functions of a radio link control (radio link control, RLC) layer, a media access control (media access control, MAC) layer, and a physical (physical, PHY) layer. Information at the RRC layer eventually becomes information at the PHY layer, or is converted from the information at the PHY layer. Therefore, in the architecture, higher layer signaling such as RRC layer signaling or PHCP layer signaling may also be considered as being sent by the DU or sent by the DU and the RU. It may be understood that the network device may be a CU node, a DU node, or a device including a CU node and a DU node. In addition, the CU may be classified as a network device in an access network RAN, or the CU may be classified as a network device in a core network CN. This is not limited herein.

The terminal device 102 may also be referred to as user equipment (user equipment, UE), a mobile station (mobile station, MS), a mobile terminal (mobile terminal, MT), or the like, and is a device that provides a user with voice or data connectivity, or may be an internet of things device. For example, the terminal device includes a handheld device, a vehicle-mounted device, or the like that has a wireless connection function. Currently, the terminal device may be a mobile phone, a tablet computer, a laptop computer, a palmtop computer, a mobile internet device (mobile internet device, MID), a wearable device (for example, a smartwatch, a smart band, or a pedometer), a vehicle-mounted device (for example, a car, a bicycle, an electric car, an airplane, a ship, a train, or a high-speed rail), a virtual reality (virtual reality, VR) device, an augmented reality (augmented reality, AR) device, a wireless terminal in industrial control, a smart household device (for example, a refrigerator, a television, an air conditioner, or a meter), an intelligent robot, workshop equipment, a wireless terminal in self driving, a wireless terminal in remote surgery, a wireless terminal in smart grid (smart grid), a wireless terminal in transportation safety, a wireless terminal in smart city, a wireless terminal in smart home, a flight device (for example, an intelligent robot, a hot air balloon, an uncrewed aerial vehicle, or an airplane), or the like. The terminal device may alternatively be another device having a terminal function. For example, the terminal device may alternatively be a device functioning as a terminal function in D2D communication. In this application, a terminal device having a wireless transceiver function and a chip that can be disposed in the terminal device are collectively referred to as the terminal device.

In embodiments of this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof means any combination of these items, including any combination of single items (pieces) or plural items (pieces). For example, at least one of a, b, or c may indicate: a, b, c, a-b, a-c, b-c, or a-b-c, where a, b, and c may be singular or plural.

Unless otherwise stated on the contrary, ordinal terms such as "first" and "second" mentioned in embodiments of this application are used to distinguish between a plurality of objects, and are not intended to limit sizes, content, a sequence, a time sequence, priorities, importance degrees, or the like of the plurality of objects. For example, a first sequence and a second sequence are merely used to distinguish between different sequences, but do not indicate a difference in lengths, priorities, importance degrees, or the like between the two sequences.

To better understand the solutions provided in embodiments of this application, the following first describes some terms, concepts, or procedures in embodiments of this application.

(1) Polar (polar) code encoding: The polar coding is a channel encoding scheme that can be strictly proved to achieve a channel capacity, and has features such as high performance, low complexity, and flexible matching manners. Currently, the polar coding has been determined by the 3rd generation partnership project (3rd generation partnership project, 3GPP) as a control channel encoding scheme for a 5G control channel enhanced mobile broadband (enhanced mobile broadband, eMBB) scenario.

FIG. 2 shows a typical polar coding process with a length of 8. Bits in a to-be-encoded bit sequence are classified into two types based on reliability of the bits: a frozen bit (frozen) and an information bit (data). Optionally, the reliability may be calculated through a log likelihood ratio (log likelihood ratio, LLR) distribution average value of a position. Generally, a bit with high reliability is set as the information bit (data), and a bit with low reliability is set as the frozen bit (frozen). A value of the frozen bit is generally set to 0, and this is known to both a transmit end and a receive end in actual transmission. An encoding code length corresponding to FIG. 2 is eight bits (bits), and FIG. 2 shows that $\{u_0, u_1, u_2, u_4\}$ are positions of frozen bits, and $\{u_3, u_5, u_6, u_7\}$ are positions of information bits. Each circle in each row represents an exclusive OR operation (or referred to as modulo-2 addition) between a bit in a row in which the circle is located and a row reached by the circle, and a bit on a right side of the circle is a summation result.

(2) Polar code construction: The polar code construction is a process of obtaining a polar code based on a given code length N and an information bit length K. Currently, during construction of a polar code, a length matching manner such as puncturing (puncture), retransmission, or shortening (shorten) needs to be first determined, then a pre-freezing position is removed based on the length matching manner, and then an information bit of the polar code is obtained based on a sequence Q. The sequence Q is for representing reliability of subchannels. A value in the sequence Q represents a sequence number of a subchannel, and a position of the value in the sequence represents reliability of the corresponding subchannel. For example, for a sequence Q with a length of 8, [0 1 2 4 3 5 6 7] indicates that a subchannel corresponding to a bit whose position is 7 in the sequence is the most reliable subchannel, a subchannel corresponding to a bit whose position is 6 is the second reliable channel, and so on. A polar code construction process is described with reference to the example. It is assumed to construct a polar code with lengths of N=6 and K=4. First, it is determined, based on a code rate, that the length matching manner is shorten, and then it is further determined that to-be-shortened positions are 6 and 7. Therefore, a sub-channel 6 and a sub-channel 7 are pre-frozen, in other words, the positions 6 and 7 cannot be selected as information positions. Therefore, before the polar code is constructed, the positions 6 and 7 in the sequence Q are first removed, to obtain [0 1 2 4 3 5], then four positions, to be specific, 2, 4, 3, and 5, are selected from back to front as information positions, and a remaining position is used as a frozen position.

(3) Nature (nature, NAT) puncturing: The nature puncturing may also be referred to as sequential puncturing, and means that for a sequence of a code length E, first N-E positions of a polar code in a nature ordering are to-be-punctured positions, where N is a mother code length of the polar code (or referred to as a code length before rate matching). The nature ordering means that polar code position values are sorted in ascending order. In an optional manner, to avoid performance breakdown, pre-freezing (pre-freezing) bit positions may be further sorted in the nature ordering based on a quantity of to-be-punctured bits (N-E), so that frozen positions are not used as information bits. Based on nature puncturing, information bits may be selected from a punctured sequence in descending reliability order.

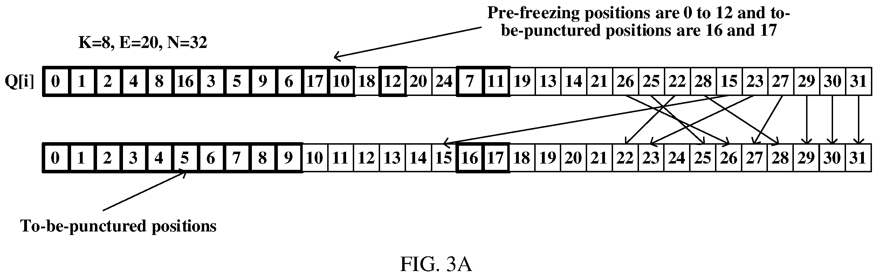

For example, the mother code length of the polar code is N, a code length for actual communication is E, and K information bits (that is, an information length is K) are included. In a manner of determining information bits based on nature puncturing, for example, first N-E positions of the polar code are marked as freezing positions (including to-be-punctured positions), and a counter (count, CNT) is cleared. Then, reading is sequentially performed from the last position of the sequence Q, and each reading is denoted as Q[i], where i=0, 1, ..., N-1. If a value of Q[i] is less than N and is greater than or equal to (N-E), a position corresponding to Q[i] is marked as an information position, and then the counter is added by 1. If a value of the counter is equal to K, an information position construction process is exited. Otherwise, the sequence Q continues to be read until the K information bits are selected. FIG. 3A shows an example of Q[i] when K=8, E=20, and N=32.

However, because puncturing affects a capacity of a subchannel, reliability of a subchannel corresponding to a bit position in the polar code is affected after bit puncturing. After bit puncturing, if the information bit is still determined based on the sequence Q determined before bit puncturing, a performance bad point may be caused, and communication performance may be decreased.

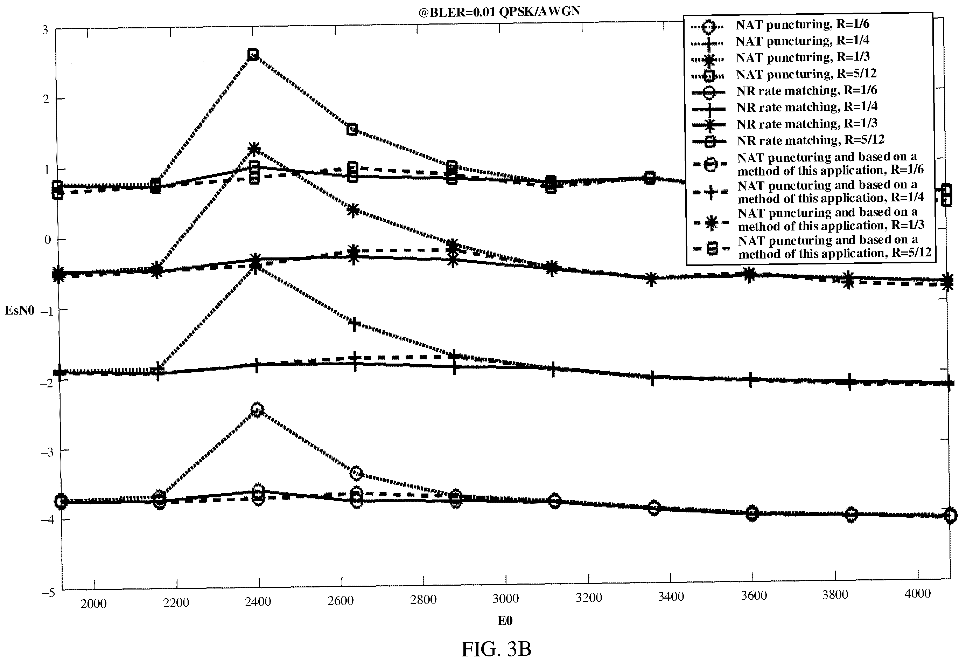

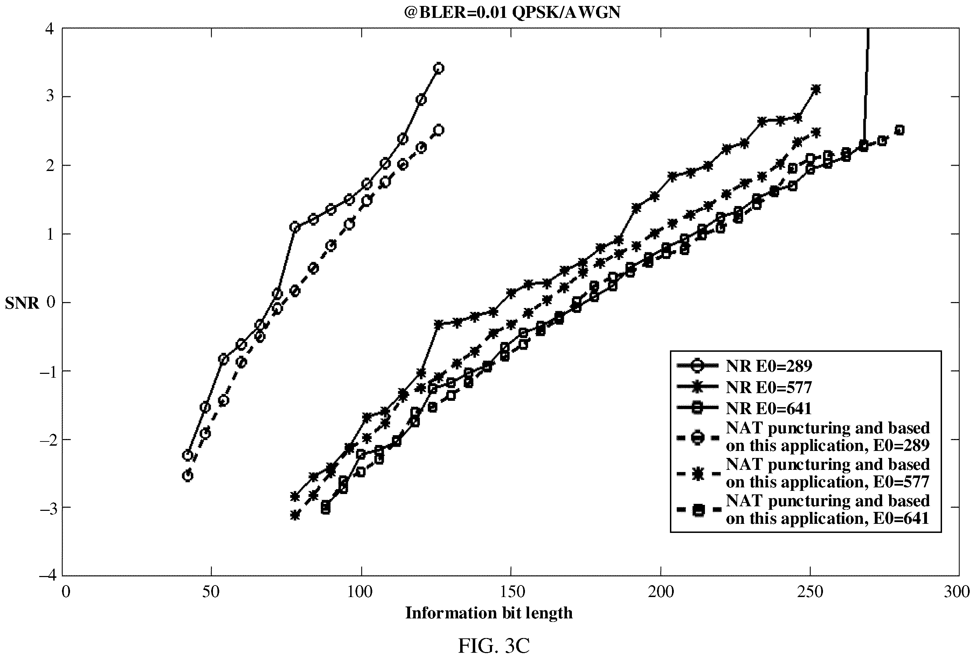

For example, as shown in FIG. 3B, a horizontal coordinate E in FIG. 3B represents a quantity of information bits, and a vertical coordinate is a symbol signal-to-noise ratio (EsN0) when a block error rate (block error rate, BLER) is $10^{-2}$. In FIG. 3B, a solid line represents SNR performance when puncturing is performed in a 5G rate matching manner, and a dot line represents signal-to-noise ratio (signal noise rat, SNR) performance after NAT puncturing is performed. It can be learned that after NAT puncturing is performed, the dot line shown in FIG. 3B has bad points at some positions in an information bit length ranging from 2200 to 2600. After puncturing, performance at some bit positions is much lower than performance when puncturing is not performed. It may be understood that, in FIG. 3B and FIG. 3C, R represents a bit rate.

Therefore, in the 5G standard, the mother code length of the polar code is divided into 32 (or another quantity) sub-blocks (sub blocks), and after sub-block interleaving is performed based on an order in Table 1, bits of the first N-E length obtained after the sub-block interleaving are punctured, and a corresponding non-interleaving position is determined as a pre-freezing position. A bit at the pre-freezing position is not used as the information bit. Then, with reference to the nature order sequence Q, Q[i] is sequentially read from the last position of the sequence Q. If Q[i] is less than N, and the bit position is not the frozen bit, the bit is selected as the information bit, and K positions are selected as the information bits by using the same method.

Table 1

| i | P(i) | i | P(i) | i | P(i) | i | P(i) | i | P(i) | i | P(i) | i | P(i) | i | P(i) |
|---|---|---|---|---|---|---|---|---|---|---|---|---|---|---|---|
| 0 | 0 | 4 | 3 | 8 | 8 | 12 | 10 | 16 | 12 | 20 | 14 | 24 | 24 | 28 | 27 |
| 1 | 1 | 5 | 5 | 9 | 16 | 13 | 18 | 17 | 20 | 21 | 22 | 25 | 25 | 29 | 29 |
| 2 | 2 | 6 | 6 | 10 | 9 | 14 | 11 | 18 | 13 | 22 | 15 | 26 | 26 | 30 | 30 |
| 3 | 4 | 7 | 7 | 11 | 17 | 15 | 19 | 19 | 21 | 23 | 23 | 27 | 28 | 31 | 31 |

For example, the mother code length N=1024, and the subblock length is 32. Assuming that E=N - 150, 150 bits are punctured, that is, 4.6875 subblocks are punctured. To be specific, four complete subblocks and 22 bits of a fifth subblock are punctured. As shown in Table 1, after sub-block interleaving, indexes of first five corresponding *P(i)* are 0, 1, 2, 4, and 3 in ascending order of *i*. Therefore, punctured positions are sub-blocks 0-2, a fourth sub-block, and first 22 bits of a third sub-block.

FIG. 3A is used as an example. Position indexes of punctured bits after subblock interleaving are 0 to 9, 16, and 17, and position indexes of selected information bits may be 15, 22, 23, 27, 28, 29, 30, and 31.

However, a subblock interleaving solution brings additional processing complexity. In addition, as shown in a solid line part in FIG. 3C, in the sub-block interleaving solution, bad points still exist in some bit positions. For example, based on the sub-block interleaving solution, when the code length is 641 and the information length K=274, a 577th bit is selected as the information bit. However, based on calculation, it is found that a capacity of a sub-channel corresponding to the 577th bit is almost equal to 0. Therefore, the 577th bit is selected as the information bit, a bad point occurs, and it can be seen from a simulation diagram in FIG. 3C that the bad points exit.

Based on this, embodiments of this application provide a communication method and apparatus, to improve communication performance during nature puncturing, without requiring subblock interleaving. The method and the apparatus are based on a same concept. The method and the apparatus have a similar problem-resolving principle. Therefore, for implementations of the apparatus and the method, refer to each other. Repeated parts are not described again.

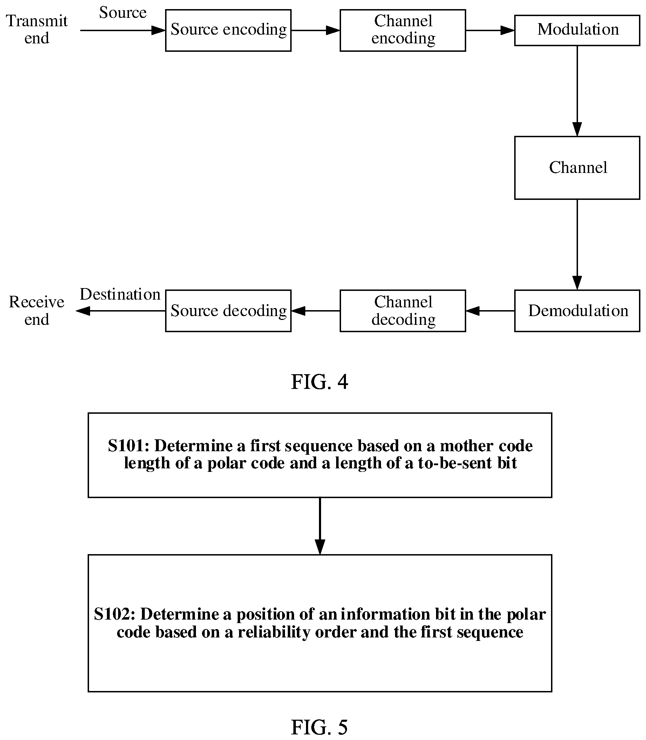

FIG. 4 is a diagram of interaction between a transmit end and a receive end. A source of the transmit end is sent on a channel after source encoding, channel encoding, rate matching, and modulation are sequentially performed. After receiving a signal, the receive end obtains a destination after demodulation, rate de-matching, channel decoding, and source decoding are sequentially performed. The method provided in embodiments of this application may be used in processes of channel coding and rate matching.

FIG. 5 is a schematic flowchart of a communication method according to this application. In the diagram, the method is described by using a communication apparatus as an execution body. The communication apparatus may be used as a transmit end and/or a receive end. The method includes the following steps.

S101: The communication apparatus determines a first sequence based on a mother code length N of a polar code and a length E of a to-be-sent bit.

The mother code length is an integer power of 2. The length E of the to-be-sent bit is a code length for actual communication.

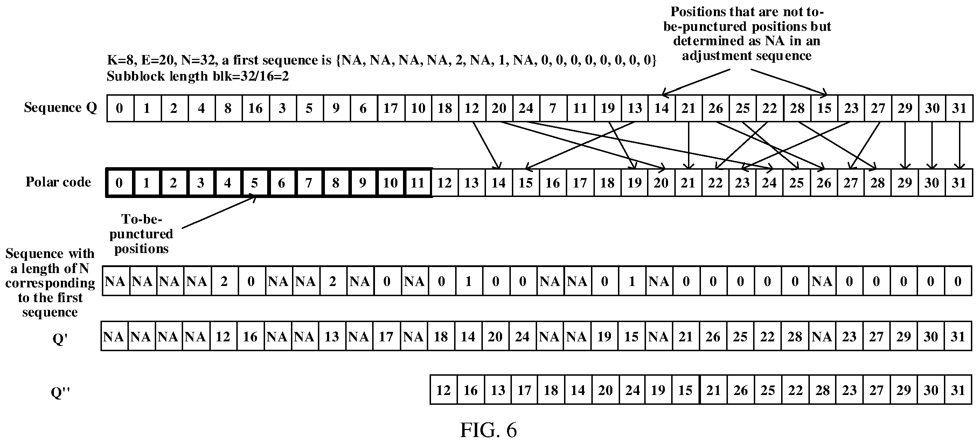

In S101, the first sequence is for adjusting a reliability order of bits in the polar code. The reliability order of the bits in the polar code may be an order of the bits in the polar code in a reliability sequence Q. For example, as shown in FIG. 6, a length of a polar code is 32, and an order of a bit 31 in the polar code in the sequence Q is 31, that is, a subchannel corresponding to the bit 31 is a most reliable subchannel.

In embodiments of this application, the first sequence may be for adjusting the order of the bits in the polar code in a reliability sequence. In other words, the first sequence may be for determining a new reliability order Q'. A quantity of elements included in the first sequence is the same as a quantity of subblocks obtained by dividing the polar code. For example, assuming that the polar code includes 16 subblocks, the first sequence may include 16 elements, and each element corresponds to one subblock. Alternatively, the quantity of elements included in the first sequence may be greater than the quantity of subblocks. The elements in the first sequence may be 0, NA, a positive integer, or a negative integer. Optionally, in the first sequence, 0 and a value whose absolute value is less than the quantity of subblocks may be referred to as an offset value, and NA and a value whose absolute value is greater than or equal to the quantity of subblocks may be referred to as an invalid value. In the following, the manner of determining an information bit is used to describe purposes of the offset value and the invalid value in S102. Details are not described herein.

Optionally, in S101, a manner for the communication apparatus to determine the first sequence based on the mother code length N of the polar code and the length E of the to-be-sent bit is, for example, determining, based on a relationship between a value of N and a value of E, the first sequence corresponding to the value range relationship.

For example, the quantity of subblocks is 16. For the relationship between the value of N and the value of E and a correspondence between first sequences, refer to Table 2. The communication apparatus may query Table 2 based on the relationship between the value of N and the value of E, to determine a corresponding first sequence.

Table 2

| Relationship between the value of N and the value of E | First sequence Seq-x, x=0, 1, ..., 7 |
|---|---|
| $15.5*N/16 < E \leq N$ | Seq-0={0, 0, 0, 0, 0, 0, 0, 0, 0, 0, 0, 0, 0, 0, 0, 0} |
| $14.5*N/16 < E \leq 15.5*N/16$ | Seq-1={1, 1, NA, 0, 0, 0, 0, 0, 0, 0, 0, 0, 0, 0, 0, 0} |
| $13.5*N/16 < E \leq 14.5*N/16$ | Seq-2={NA, 1, 1, NA, 0, 0, 0, 0, 0, 0, 0, 0, 0, 0, 0, 0} |
| $12.5*N/16 < E \leq 13.5*N/16$ | Seq-3={NA, NA, 2, NA, -1, 0, 0, 0, 0, 0, 0, 0, 0, 0, 0, 0} |
| $11.5 * N/16 < E \leq 12.5 * N/16$ | Seq-4={NA, 3, NA, 2, NA, 1, NA, 0, 0, 0, 0, 0, 0, 0, 0, 0} |
| $10.5*N/16 < E \leq 11.5*N/16$ | Seq-5={NA, NA, NA, 3, 1, NA, 1, NA, 0, 0, 0, 0, 0, 0, 0, 0} |
| $9.5*N/16 < E \leq 10.5*N/16$ | Seq-6={NA, NA, NA, NA, 2, NA, 1, NA, 0, 0, 0, 0, 0, 0, 0, 0} |
| $8*N/16 < E \leq 9.5*N/16$ | Seq-7={NA, NA, NA, 4, NA, NA, NA, NA, 0, 0, 0, 0, 0, 0, 0, 0} |

Optionally, in S101, the communication apparatus may alternatively determine the first sequence based on a quantity of to-be-punctured bits and the mother code length. The quantity of to-be-punctured bits may be determined based on the mother code length N and the length E of the to-be-sent bit. For example, the quantity of to-be-punctured bits is (N-E).

Still for example, the quantity of subblocks is 16, for a relationship between the quantity of to-be-punctured bits and the value of N and a correspondence between first sequences, refer to Table 3.

Table 3

| Relationship between the quantity of to-be-punctured bits and the value of N | First sequence Seq-x, x=0, 1, ..., 7 |
|---|---|
| 0≤N-E <0.5*N/16 | Seq-0={0, 0, 0, 0, 0, 0, 0, 0, 0, 0, 0, 0, 0, 0, 0, 0} |
| 0.5*N/16 ≤N-E <1.5*N/16 | Seq-1={1, 1, NA, 0, 0, 0, 0, 0, 0, 0, 0, 0, 0, 0, 0, 0} |
| 1.5*N/16≤N-E<2.5*N/16 | Seq-2={NA, 1, 1, NA, 0, 0, 0, 0, 0, 0, 0, 0, 0, 0, 0, 0} |
| 2.5*N/16 ≤N-E<3.5*N/16 | Seq-3={NA, NA, 2, NA, -1, 0, 0, 0, 0, 0, 0, 0, 0, 0, 0, 0} |
| 3.5*N/16 ≤N-E <4.5*N/16 | Seq-4={NA, 3, NA, 2, NA, 1, NA, 0, 0, 0, 0, 0, 0, 0, 0, 0} |
| 4.5*N/16 ≤N-E <5.5*N/16 | Seq-5={NA, NA, NA, 3, 1, NA, 1, NA, 0, 0, 0, 0, 0, 0, 0, 0} |
| 5.5*N/16 ≤N-E <6.5*N/16 | Seq-6={NA, NA, NA, NA, 2, NA, 1, NA, 0, 0, 0, 0, 0, 0, 0, 0} |
| 6.5*N/16≤N-E<8*N/16 | Seq-7={NA, NA, NA, 4, NA, NA, NA, NA, 0, 0, 0, 0, 0, 0, 0, 0} |

It may be understood that values in Table 2 and Table 3 are merely examples for descriptions, and do not indicate that in actual application, a correspondence can only be limited to those shown in Table 2 and Table 3. For example, based on an actual application requirement, a value boundary of N may be adjusted, and/or a value of a heavy element of the first sequence may be adjusted. In addition, the symbol "≤" in Table 2 and Table 3 may be replaced with "<", and "<" may be replaced with "≤". Optionally, in Table 2 and Table 3, NA may also be replaced with a value whose absolute value is greater than or equal to the quantity of subblocks.

It can be learned that, for a same N and a same E, first sequences determined based on Table 2 and Table 3 are the same.

S102: The communication apparatus determines a position of an information bit in the polar code based on a reliability order and the first sequence.

In S102, the communication apparatus may select an offset value from the first sequence based on a first position value based on a first position value of the bit in the polar code, and then determine a second position value of the bit in the polar code based on the offset value and the first position value, where the second position value is a position index of the information bit in the polar code.

For example, the communication apparatus may select $Q[i]$ as the first position value in descending order of elements in the reliability sequence Q, and then determine the offset value from the first sequence based on the first position value. $Q[i]$ is an $i^{th}$ element in the reliability sequence Q, and a value of $Q[i]$ is a position index, in the polar code, of a bit with an $i^{th}$ highest reliability of a subcarrier in the polar code.

When determining the offset value, the communication apparatus may determine the offset value from a plurality of elements of the first sequence based on a sequence number of a subblock to which the first position value $Q[i]$ belongs. The sequence number of the subblock to which the first position value belongs is n, and the sequence number of the subblock may be represented as $n=\lfloor Q[i]/(N/M) \rfloor$, where $\lfloor \rfloor$ represents a round-down operation, and N/M represents a subblock length. Optionally, N/M may be a positive number. In other words, N may be exactly divided by M. For example, assuming that the sequence number of the subblock to which the first position value belongs is n, the offset value is an $n^{th}$ element in the first sequence, where n=0, 1, ..., M-1, and M is the quantity of subblocks.

Further, the communication apparatus may determine the second position value based on the offset value, the subblock length, and the first position value, that is, may determine the position index of the information bit in the polar code based on the offset value, the subblock length, and the first position value. For example, the second position value is represented as $Q'[i]=(Q[i]+p*(N/M))$, where $Q[i]$ represents the first position value, p represents the offset value, N/M represents the subblock length, N represents the mother code length, and M is the quantity of subblocks. If the offset value is 0, it indicates that the second position value is the same as the first position value $Q[i]$. In this case, the communication apparatus may use $Q[i]$ as the information bit. For example, if $Q[i]=31$, and a corresponding offset value is 0, $Q'[i]=Q[i]=31$ is used as the position index of the information bit. If the offset value is an integer whose absolute value is less than M, optionally, the communication apparatus may use a bit $(Q[i]+p*(N/M))$ in the polar code as the second position value, that is, use the bit $(Q[i]+p*(N/M))$ in the polar code as the information bit. The second position value is a positive integer greater than or equal to 0 and less than N. For example, as shown in FIG. 6, the subblock length is 2. When the communication apparatus uses $Q[i]=13$ in the sequence Q as the first position value, it may be determined that n=6. Therefore, $Q[i]=14$ corresponds to a seventh element in the first sequence, that is, 1, and $Q[i]+p*(N/M)=13+1$ *2=15. Therefore, the communication apparatus may use a bit whose position index is 15 in the polar code as the information bit.

In this application, one of prerequisites for using the second position value as the information bit is that the second position value does not belong to the pre-freezing position, and a quantity of determined information bits is less than K. In this application, the communication apparatus may further determine a pre-freezing position of a bit in the polar code, and the bit at the pre-freezing position is not used as the position of the information bit. For example, when the position of the information bit is determined based on the first sequence shown in Table 2 or Table 3, it further needs to be determined that the information bit does not belong to the pre-freezing position. For example, the position of the information bit does not belong to P minimum position indexes in the position indexes in the polar code.

Optionally, a quantity of pre-freezing positions may be determined based on the mother code length and the length of the to-be-sent bit. For example, a quantity P of pre-freezing positions may meet:

$$P=N-\text{floor}(E/(N/32))*(N/32),$$

and E cannot be exactly divided by 32; and

$$P=N-E+(N/32),$$

and E can be exactly divided by 32.

floor() represents rounding down.

Assuming that N=1024 and E can be exactly divided by 32, the quantity P of pre-freezing positions is 1056-E, and E is a quantity of information bits. In addition, based on a nature puncturing solution, the first (1024 - E) positions of the polar code with a length of 1024 are to-be-punctured positions. Therefore, in addition to the to-be-punctured positions, extra 32 bits need to be frozen.

In addition, if the communication apparatus selects the invalid value from the first sequence based on the first position value, the communication apparatus may determine, based on the invalid value, not to solve the position index of the information bit based on the first position value. A manner of selecting the invalid value is similar to a manner of selecting the offset value. For example, the communication apparatus may determine a sequence number n of the subblock of the first position value based on the first position value and the subblock length, and read an $n^{th}$ element from the first sequence based on the sequence number n of the subblock, where the $n^{th}$ element is the invalid value. Optionally, the subblock length may alternatively be replaced with a ratio of the mother code length to the quantity of subblocks. The invalid value indicates that determining the information bit based on the current first position value Q[i] is ignored, or indicates that the second position value cannot be determined based on the current first position value Q[i]. Optionally, when the communication apparatus selects the invalid value from the first sequence based on the first position value, the communication apparatus may select a position index of a next bit in the polar code as a newly selected first position value, and determine the position of the information bit based on the newly selected first position value. The position index of the next bit may be a next bit position value that is determined based on the sequence Q and that is in a relatively low reliability order. For example, as shown in FIG. 6, the subblock length is 2. When the communication apparatus uses Q[i]=14 in the sequence Q as the first position value, it may be determined that n=7. Therefore, Q[i]=14 corresponds to an eighth element in the first sequence, that is, NA is the invalid value. Therefore, the communication apparatus may stop determining the information bit based on Q[i]=14. The communication apparatus may continue to select a new bit index from the sequence Q as the first position value. For example, the communication apparatus may use Q[i]=13 as the newly selected first position value based on the reliability order.

For example, K=8, E=20, and N=32. The first sequence is {NA, NA, NA, NA, 2, NA, 1, NA, 0, 0, 0, 0, 0, 0, 0, 0}, and an adjusted sequence Q' is shown in FIG. 6. If a value of the $n^{th}$ element in the first sequence is the invalid value, a value of an $i^{th}$ element in the sequence Q' is the invalid value. Referring to the foregoing descriptions, $n=\lfloor Q[i]/(N/M)\rfloor$, where Q[i] represents the first position value, p represents the offset value, N/M represents the subblock length, N represents the mother code length, and M is the quantity of subblocks. It can be learned that if the value of the $n^{th}$ element in the first sequence is the offset value (that is, is not the invalid value), Q'[i]=(Q[i]+p*(N/M)). It can be learned that when the value of the $n^{th}$ element is the offset value (that is, is not the invalid value), an $i^{th}$ element Q'[i] in Q'[i] represents a position index of an information bit corresponding to an $i^{th}$ element Q[i] in the sequence Q, that is, the second position value. For example, when the communication apparatus selects Q[i] as the first position value based on the reliability order, the communication apparatus may determine the position index of the information bit based on the element Q'[i] in the sequence Q'. For example, when Q[i]=31, n=16, and a sixteenth element in the first sequence is the offset value 0. Therefore, Q'[i]=31. In this case, a bit whose index position is 31 in the polar code may be used as the information bit.

For another example, when Q[i]=14, n=7, and the seventh element in the first sequence is the invalid value NA. Therefore, Q'[i]=NA. In this case, a corresponding information bit cannot be determined based on a bit whose index position is 14 in the polar code. Optionally, it can be learned from the sequence Q in FIG. 6 that reliability of a bit whose bit index is Q[i]=13 in the polar code is only second to reliability of a bit whose bit index is Q[i]=14. Therefore, the communication apparatus may alternatively use Q[i]=13 as a next first position value. In this case, n=6, and a sixth element in the first sequence is the offset value 1. Therefore, Q'[i]=15. In this case, a bit whose index position is 15 in the polar code may be used as the information bit.

It may be understood that a quantity of bits corresponding to NA in the sequence Q' is less than or equal to a sum of a quantity of to-be-punctured positions and a quantity of non-punctured pre-freezing positions. In a specific example, index positions in the sequence Q' after NA is marked may be considered as a shorter sequence. As shown in FIG. 6, a sequence Q" is a sequence including elements obtained after NA is removed from the sequence Q'. A position value order in the sequence Q" corresponds to a reliability order adjusted based on the first sequence. For example, in FIG. 6, the position value order corresponds to the reliability order in descending order from right to left. Position indexes that are not included in the sequence Q" are position indexes of the pre-freezing positions in the polar code. In FIG. 6, bits 0 to 11 in the polar code are to-be-punctured positions (the pre-freezing positions include the to-be-punctured positions). In addition, in this example, because a length of the polar code is relatively short, the pre-freezing bits are bits 0 to 11, that is, no extra bits need to be frozen other than the to-be-punctured positions.

Optionally, refer to the foregoing descriptions of the example shown in FIG. 6. When performing S102, the communication apparatus may determine the information bit based on a first information bit and the first sequence, or may determine the information bit based on the first information bit and the sequence shown in the sequence Q', or may determine the information bit based on the first information bit and a sequence with a length of N (for example, may be referred to as the second sequence) corresponding to the first sequence, where N is the mother code length of the polar code. As shown in FIG. 6, N elements in the sequence with a length of N corresponding to the first sequence are in a one-to-one correspondence with N bits in the sequence Q. An $i^{th}$ element P'[i] in the sequence with a length of N is a value of the first sequence corresponding to the $i^{th}$ element Q[i] in the sequence Q (that is, the value of the $n^{th}$ element in the first sequence). It is assumed that the first sequence is represented as P, the $n^{th}$ element is represented as P[n], and the sequence with a length of N corresponding to the first sequence is represented as P', where the $i^{th}$ element is represented as P'[i]. In this case, P'[i]=P[n], and the foregoing description is still used, $n=\lfloor Q[i]/(N/M)\rfloor$, i=0, 1, ..., N-1, and n=0, 1, ..., M-1.

In addition, the communication apparatus may alternatively determine the information bit based on the sequence Q". Based on the sequence Q" shown in FIG. 6, when determining the information bit, the communication apparatus may sequentially select one bit in the polar code based on the reliability order from right to left, and determine whether a reliability order of the bit belongs to first K bits with the highest reliability order, where K is a total quantity of information bits. If the reliability order belongs to the first K bits, the position index may be determined as the position index of the information bit. For example, K=6. K position indexes with the highest reliability order in the sequence Q" are {31, 30, 29, 27, 23, 28}. Therefore, the position indexes of the information bits in the polar code are {31, 30, 29, 27, 23, 28}. If the K position indexes with the highest reliability order are determined as the information bits based on the sequence Q, bits whose position indexes are {31, 30, 29, 27, 23, 15} are used as the information bits.

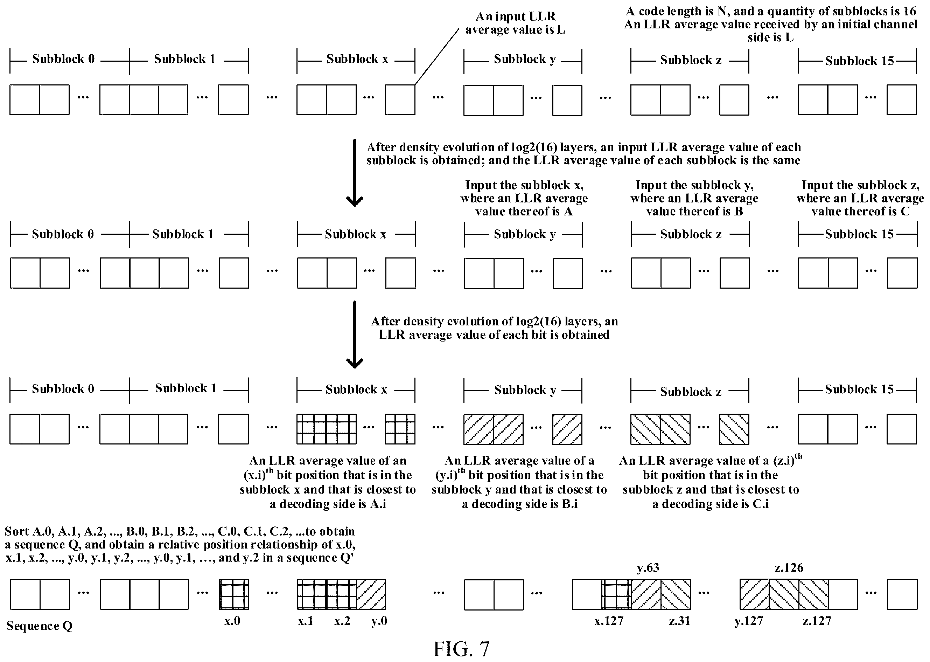

The following describes, with reference to FIG. 7, a principle of adjusting the sequence Q in the method provided in embodiments of this application.

The mother code length N is divided into 16 subblocks, and for a subchannel on each codeword side, an LLR average value received by a channel is L. After density evolution of $\log_2(16)$ layers, an LLR average value of each subchannel of a subblock x becomes A, an LLR average value of each subchannel of a subblock y becomes B, and an LLR average value of each subchannel of a subblock z becomes C. Density evolution continues to be performed in a subsequent subblock. Therefore, the LLR average value of the subchannel of each bit in the subblock x after full polarization becomes A.i. $i$=0, 1, 2, ..., $N/M$-1. The LLR average value of the subchannel of each bit in the subblock y after full polarization becomes B.i, and the LLR average value of the subchannel of each bit in the subblock z after full polarization becomes C.i.

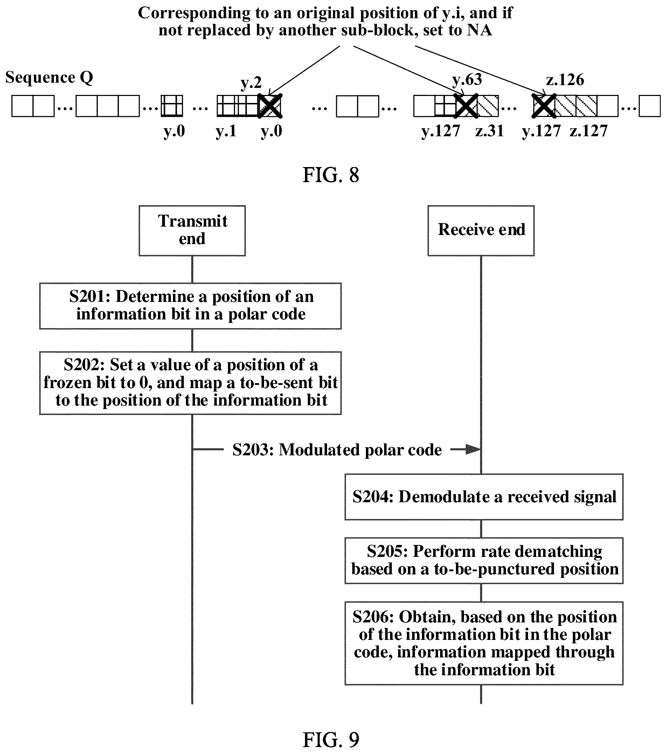

After all values in A.i, B.i, and C.i are sorted, an order of the subblocks x, y, and z in the reliability sequence Q is determined. After puncturing is performed at many positions, an LLR average value B' of the subblock y after density evolution of the $\log_2(16)$ layers is far different from the value B during construction, but is relatively close to the value A. An LLR average value C' of the subblock x after density evolution of the $\log_2(16)$ layers is still almost the same as the original C. Because it is known that B' is close to A, and it is also known that the sequence Q includes a sorting relationship between A.i and C.i on a channel side after density evolution is performed on A and after density evolution is performed on C, a position of x in the sequence Q is used to represent new y. Therefore, there is an adjustment sequence O (that is, the first sequence), where O[x]=y-x. After the sequence Q is read, if $n=\lfloor Q[i]/(N/M)\rfloor=x$, a read adjustment value is y - x, and a position index in the subblock y is obtained based on (Q[i]+(x-y)*(N/M)). After the sequence Q shown in FIG. 7 is adjusted based on the sequence O, a sequence Q shown in FIG. 8 may be obtained. Values (that is, the sequence Q in FIG. 8) of positions such as x.0, x.1, x.2, and x.127 (represented by square shadows) in the sequence Q' after adjustment are values of positions such as y0, y1, y2, and y.127 (represented by diagonal shadows from bottom left to top right) in the sequence Q in FIG. 7.

For the subblock x, if the subblock x is punctured or pre-frozen, a replacement sequence of the subblock x does not need to be considered. If the subblock x is not punctured, a corresponding subblock w (not shown in FIG. 8) is used to replace x, and O[w]=x-w.

Based on the procedure shown in FIG. 5, the communication apparatus may determine the position of the information bit based on the reliability order and the first sequence. Because the position of the information bit is not determined based on the reliability order only, but adjustment is performed on the reliability order through the first sequence to determine the position of the information bit, a bad point can be avoided, and communication performance can be improved. For example, as shown in FIG. 3B, a dashed line part represents symbol signal-to-noise ratio performance in different information lengths when NAT puncturing is used and the position of the information bit is determined based on the method provided in this application. It can be learned that, according to the method provided in this application, a bad point can be avoided when NAT puncturing is used, and communication performance can be improved. In addition, as shown in FIG. 3C, compared with the subblock interleaving solution, based on the method provided in this application (as shown by a dashed line in FIG. 3C), a point whose capacity is 0 is not selected as the information bit, so that the bad point can be avoided when 5G subblock interleaving and puncturing are used, thereby improving communication performance.

For example, $N*9.5/16 \leq E < N*10.5/16$. When determining the information bit, the communication apparatus first uses (N-E) bits with the smallest position index and some extra bits as the pre-freezing positions. Therefore, the pre-freezing position size (pre-freeze-size) may be represented as pre-freeze-size=N-floor(E/(N/32))*(N/32).

Due to a puncturing operation, when the information bits are determined, bits in the part of $N*7/16 \leq Q[i] < N*8/16$ are replaced with bits in the part of $N*6/1 \leq Q[i] < N*7/16$. After bits in the part of $N*6/16 \leq Q[i] < N*7/16$ are occupied, the bits in the part of $N*6/16 \leq Q[i] < N*7/16$ are replaced by bits in the part of $N*4/16 \leq Q[i] < N*5/16$ through translation. A replacement process may be represented through the first sequence.

A pseudo code of a specific example may be represented as:

```
If(N*9/16<=E<N*10/16)

{   if(N*1/2<=Q[i]<N)

    {   if((Q[i])>pre-freeze-size) info[Q[i]]=true; //a part that does not need to be moved

    } else

    else if(N*6/16<=Q[i]<N*7/16)

    {   if((Q[i]+N/16)>pre-freeze-size) info[Q[i]+N/16]=true; // translate an area of N/16

    } else if (N*4/16<=Q[i] <N*5/16)

      {   if((Q[i]+N*2/16)> pre-freeze-size) info[Q[i]+N*2/16]=true; // translate an area of N*2/16

      }

}
```

Still using $N*9.5/16 \leq E < N*10.5/16$ as an example, when determining the information bit, the communication apparatus first uses (N-E) bits with the smallest position indexes and some extra bits floor(E/(N/32))*(N/32) as the pre-freezing positions. Therefore, the pre-freezing positions may be represented as pre-freeze-size=N-floor(E/(N/32))*(N/32).

Assuming that N=4096 and the quantity of subblocks is 16, each subblock has a length of 256. When $N*9/16 \leq E < N*10/16$, it may be determined, based on Table 2 or Table 3, that the first sequence is Seq-6={NA, NA, NA, NA, 2, NA, 1, NA, 0, 0, 0, 0, 0, 0, 0, 0}.

The pseudo code is:

```
id=Q[i]/256;

shift=S[id];
```

$$\text{if((S[id] !=NA) \& ((S[id]*256+Q[i])>pre-freeze-size))}$$

$$\{ \quad \text{info[Q[i]+S[id]*256]=true;}$$

$$\}$$

As shown in FIG. 9, embodiments of this application further provide a method, which is implemented by a transmit end and a receive end. The method may include the following steps.

S201: A transmit end determines a position of an information bit in a polar code.

For a manner in which the transmit end determines the position of the information bit, refer to the procedure shown in FIG. 5. Details are not described herein again.

S202: The transmit end sets a value of a position of a frozen bit to 0, and maps a to-be-sent bit to the position of the information bit.

S203: The transmit end modulates the polar code and sends a modulated polar code through a channel.

S204: A receive end demodulates a received signal.

S205: The receive end performs rate dematching based on a to-be-punctured position.

S206: The receive end obtains, based on the position of the information bit in the polar code, information mapped through the information bit, that is, obtains information transmitted by the transmit end.

The receive end may determine the position of the information bit with reference to the procedure shown in FIG. 5. Details are not described herein again.

It may be understood that, to implement functions in the foregoing embodiments, embodiments of this application further provide a communication apparatus. The communication apparatus may include a corresponding hardware structure and/or software module for performing the functions. A person skilled in the art should be easily aware that, in combination with the units and the method steps in the examples described in embodiments disclosed in this application, this application can be implemented by using hardware or a combination of hardware and computer software. Whether a function is performed by hardware or hardware driven by computer software depends on particular application scenarios and design constraint conditions of the technical solutions.

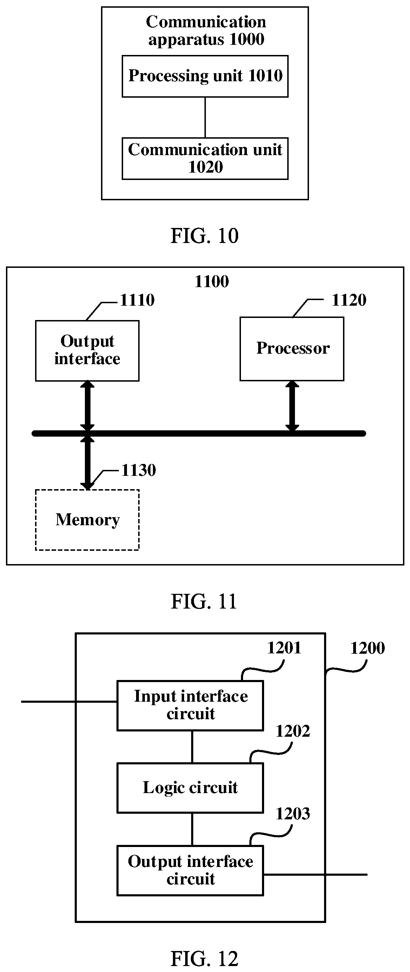

FIG. 10 to FIG. 12 are diagrams of a structure of a possible communication apparatus according to an embodiment of this application. The communication apparatus may be configured to implement functions corresponding to the foregoing method embodiments, and therefore can also implement beneficial effects of the foregoing method embodiments. In a possible implementation, the communication apparatus may be the network device or the terminal device shown in FIG. 1. For related details and effects, refer to the descriptions in the foregoing embodiments.

As shown in FIG. 10, the communication apparatus 1000 includes a processing unit 1010 and a communication unit 1020. The communication unit 1020 may alternatively be a transceiver unit, an input/output interface, or the like. The communication apparatus 1000 may be configured to implement functions of the transmit end or the receive end in the method embodiments shown in FIG. 5 and/or FIG. 9.

Optionally, when the method is performed by the transmit end, the communication unit 1020 may be configured to obtain an information bit. The processing unit 1010 may be configured to determine a first sequence based on a mother code length of a polar code and a length of a to-be-sent bit, where the mother code length is a positive integer power of 2, and the first sequence is for adjusting a reliability order of bits in the polar code, and determine a position of the information bit in the polar code based on the reliability order and the first sequence. Optionally, the communication unit 1020 may be configured to send or receive information mapped to the position of the information bit.

Optionally, the processing unit 1010 may be specifically configured to obtain a first position value of a bit in the polar code, select an offset value from the first sequence based on the first position value, and determine a second position value of the bit in the polar code based on the offset value and the first position value, where the second position value is a position index of the information bit in the polar code.

Optionally, the processing unit 1010 is further configured to select an invalid value from the first sequence based on the first position value, and determine, based on the invalid value, not to solve the position index of the information bit in the polar code based on the first position value.

Optionally, the processing unit 1010 may be specifically configured to determine, based on the first position value and a subblock length, a sequence number of a subblock to which the first position value belongs, and determine the offset value from a plurality of elements in the first sequence based on the sequence number.

Optionally, the second position value is determined based on the offset value, the first position value, and the subblock length.

Optionally, the processing unit 1010 may be further configured to determine a pre-freezing position of the bit of the polar code based on the mother code length and the length of the to-be-sent bit, where the pre-freezing position is not used as the position of the information bit.

Optionally, if a code length E of the to-be-sent bit is not exactly divided by N/32, a quantity P of pre-freezing positions meets:

$$P=N-floor(E/(N/32))*(N/32),$$

or

if E is exactly divided by N/32, the quantity P of pre-freezing positions meets:

$$P=N-E+(N/32),$$

where

N represents the mother code length of the polar code, and floor() represents rounding down.

Optionally, when 15.5*N/16<E≤N, the first sequence is {0, 0, 0, 0, 0, 0, 0, 0, 0, 0, 0, 0, 0, 0, 0, 0}, where N is the mother code length, and E is the length of the to-be-sent bit;

when 14.5*N/16<E≤15.5*N/16, the first sequence is {1, 1, NA, 0, 0, 0, 0, 0, 0, 0, 0, 0, 0, 0, 0}, where N is the mother code length, and E is the length of the to-be-sent bit;
when 13.5*N/16<E≤14.5*N/16, the first sequence is {NA, 1, 1, NA, 0, 0, 0, 0, 0, 0, 0, 0, 0, 0, 0}, where N is the mother code length, and E is the length of the to-be-sent bit;
when 12.5*N/16<E≤13.5*N/16, the first sequence is {NA, NA, 2, NA, -1, 0, 0, 0, 0, 0, 0, 0, 0, 0, 0}, where N is the mother code length, and E is the length of the to-be-sent bit;
when 11.5*N/16<E≤12.5*N/16, the first sequence is {NA, 3, NA, 2, NA, 1, NA, 0, 0, 0, 0, 0, 0, 0, 0}, where N is the mother code length, and E is the length of the to-be-sent bit;
when 10.5*N/16<E≤11.5*N/16, the first sequence is {NA, NA, NA, 3, 1, NA, 1, NA, 0, 0, 0, 0, 0, 0, 0}, where N is the mother code length, and E is the length of the to-be-sent bit;
when 9.5*N/16<E≤10.5*N/16, the first sequence is {NA, NA, NA, NA, 2, NA, 1, NA, 0, 0, 0, 0, 0, 0, 0}, where N is the mother code length, and E is the length of the to-be-sent bit; and
when 8*N/16<E≤9.5*N/16, the first sequence is {NA, NA, NA, 4, NA, NA, NA, NA, 0, 0, 0, 0, 0, 0, 0}, where N is the mother code length, and E is the length of the to-be-sent bit.

When an action performed by the transmit end is implemented, the communication unit 1020 may be configured to receive first information, where the first information includes a mother code length of a polar code and a length of a to-be-sent bit, and the mother code length is a positive integer power of 2; and the processing unit 1010 may be further configured to determine a first sequence based on the mother code length of the polar code and the length of the to-be-sent bit, where the first sequence is for adjusting a reliability order of bits in the polar code, determine a position of an information bit in the polar code based on the reliability order and the first sequence, and decode, based on the position of the information bit, data encoded by using the polar code.

Optionally, the communication unit 1020 may be further configured to receive, through an air interface, data that is encoded by using the polar code and that is from the transmit end.

Optionally, the processing unit 1010 may be specifically configured to obtain a first position value of a bit in the polar code, select an offset value from the first sequence based on the first position value, and determine a second position value of the bit in the polar code based on the offset value and the first position value, where the second position value is a position index of the information bit in the polar code.

Optionally, the processing unit 1010 is further configured to select an invalid value from the first sequence based on the first position value, and determine, based on the invalid value, not to solve the position index of the information bit in the polar code based on the first position value.

Optionally, the processing unit 1010 may be specifically configured to determine, based on the first position value and a subblock length, a sequence number of a subblock to which the first position value belongs, and determine the offset value from a plurality of elements in the first sequence based on the sequence number.

Optionally, the second position value is determined based on the offset value, the first position value, and the subblock length.

Optionally, the processing unit 1010 may be further configured to determine a pre-freezing position of the bit of the polar code based on the mother code length and the length of the to-be-sent bit, where the pre-freezing position is not used as the position of the information bit.

Optionally, if a code length E of the to-be-sent bit is not exactly divided by N/32, a quantity P of pre-freezing positions meets:

$$P=P=N-floor(E/(N/32))*(N/32),$$

or

if E is exactly divided by N/32, the quantity P of pre-freezing positions meets:

$$P=N-E+(N/32),$$

where

N represents the mother code length of the polar code, and floor() represents rounding down.

Optionally, when $15.5*N/16<E\leq N$, the first sequence is {0, 0, 0, 0, 0, 0, 0, 0, 0, 0, 0, 0, 0, 0, 0, 0}, where N is the mother code length, and E is the length of the to-be-sent bit;

when $14.5*N/16<E\leq 15.5*N/16$, the first sequence is {1, 1, NA, 0, 0, 0, 0, 0, 0, 0, 0, 0, 0, 0, 0, 0}, where N is the mother code length, and E is the length of the to-be-sent bit;

when $13.5*N/16<E\leq 14.5*N/16$, the first sequence is {NA, 1, 1, NA, 0, 0, 0, 0, 0, 0, 0, 0, 0, 0, 0, 0}, where N is the mother code length, and E is the length of the to-be-sent bit;

when $12.5*N/16<E\leq 13.5*N/16$, the first sequence is {NA, NA, 2, NA, -1, 0, 0, 0, 0, 0, 0, 0, 0, 0, 0, 0}, where N is the mother code length, and E is the length of the to-be-sent bit;

when $11.5*N/16<E\leq 12.5*N/16$, the first sequence is {NA, 3, NA, 2, NA, 1, NA, 0, 0, 0, 0, 0, 0, 0, 0, 0}, where N is the mother code length, and E is the length of the to-be-sent bit;

when $10.5*N/16<E\leq 11.5*N/16$, the first sequence is {NA, NA, NA, 3, 1, NA, 1, NA, 0, 0, 0, 0, 0, 0, 0, 0}, where N is the mother code length, and E is the length of the to-be-sent bit;

when $9.5*N/16<E\leq 10.5*N/16$, the first sequence is {NA, NA, NA, NA, 2, NA, 1, NA, 0, 0, 0, 0, 0, 0, 0, 0}, where N is the mother code length, and E is the length of the to-be-sent bit; and

when $8*N/16<E\leq 9.5*N/16$, the first sequence is {NA, NA, NA, 4, NA, NA, NA, NA, 0, 0, 0, 0, 0, 0, 0, 0}, where N is the mother code length, and E is the length of the to-be-sent bit.

Division into the modules in embodiments of this application is an example, is merely division into logical functions, and may be other division during actual implementation. In addition, functional modules in embodiments of this application may be integrated into one processor, or each of the modules may exist alone physically, or two or more modules may be integrated into one module. The integrated module may be implemented in a form of hardware, or may be implemented in a form of a software functional module.

FIG. 11 shows a communication apparatus 1100 according to an embodiment of this application. The communication apparatus 1100 is configured to implement the communication method provided in this application. The communication apparatus 1100 may be a communication apparatus to which the communication method is applied, or may be a component in the communication apparatus, or may be an apparatus that can be used in combination with a communication apparatus. The communication apparatus 1100 may be a transmit end or a receive end. The communication apparatus 1100 may be a chip system or a chip. In embodiments of this application, the chip system may include a chip, or may include a chip and another discrete component. The communication apparatus 1100 includes at least one processor 1120, configured to implement the communication method provided in embodiments of this application. The communication apparatus 1100 may further include an output interface 1110, and the output interface may also be referred to as an input/output interface. In embodiments of this application, the output interface 1110 may be configured to communicate with another apparatus through a transmission medium, and a function of the output interface 1110 may include sending and/or receiving. For example, when the communication apparatus 1100 is a chip, the communication apparatus 1100 performs transmission with another chip or component through the output interface 1110. The processor 1120 may be configured to implement the method described in the foregoing method embodiments.

For example, the processor 1120 may be configured to perform an action performed by the processing unit 1010, and the output interface 1110 may be configured to perform an action performed by the communication unit 1020. Details are not described again.

Optionally, the communication apparatus 1100 may further include at least one memory 1130, configured to store program instructions and/or data. The memory 1130 is coupled to the processor 1120. The coupling in embodiments of this application may be an indirect coupling or a communication connection between apparatuses, units, or modules in an electrical form, a mechanical form, or another form, and is used for information exchange between the apparatuses, the units, or the modules. The processor 1120 may operate in cooperation with the memory 1130. The processor 1120 may execute the program instructions stored in the memory 1130. At least one of the at least one memory may be integrated with the processor.

In embodiments of this application, the memory 1130 may be a nonvolatile memory, for example, a hard disk drive (hard disk drive, HDD) or a solid-state drive (solid-state drive, SSD), or may be a volatile memory (volatile memory), for example, a random access memory (random access memory, RAM). The memory is any other medium that can carry or store expected program code in a form of an instruction structure or a data structure and that can be accessed by a computer, but is not limited thereto. The memory in embodiments of this application may alternatively be a circuit or any other apparatus that can implement a storage function, and is configured to store the program instructions and/or the data.

In this embodiment of this application, the processor 1120 may be a general-purpose processor, a digital signal processor, an application-specific integrated circuit, a field programmable gate array or another programmable logic device, a discrete gate or transistor logic device, or a discrete hardware component, and may implement or perform the methods, steps, and logical block diagrams disclosed in embodiments of this application. The general-purpose processor may be a microprocessor or any conventional processor or the like. The steps of the method disclosed with reference to embodiments of this application may be directly performed by a hardware processor, or may be performed by using a combination of hardware in the processor and a software module.

FIG. 12 shows a communication apparatus 1200 according to an embodiment of this application. The communication apparatus 1200 is configured to implement the communication method provided in this application. The communication apparatus 1200 may be a communication apparatus to which the communication method shown in embodiments of this application is applied, or may be a component in the communication apparatus, or may be an apparatus that can be used in combination with a communication apparatus. The communication apparatus 1200 may be a transmit end or a receive end. The communication apparatus 1200 may be a chip system or a chip. In embodiments of this application, the chip system may include a chip, or may include a chip and another discrete component. Some or all of the communication methods in which a Huygens equivalent surface is applied provided in the foregoing embodiments may be implemented by hardware or may be implemented by software. When the communication method is implemented by hardware, the communication apparatus 1200 may include an input interface circuit 1201, a logic circuit 1202, and an output interface circuit 1203.

Optionally, for example, the apparatus is configured to implement a function of the receive end. The input interface circuit 1201 may be configured to perform a receiving action performed by the communication unit 1020, the output interface circuit 1203 may be configured to perform a sending action performed by the communication unit 1020, and the logic circuit 1202 may be configured to perform an action performed by the processing unit 1010. Details are not described again.

Optionally, in a specific implementation, the communication apparatus 1200 may be a chip or an integrated circuit.

Some or all of operations and functions performed by the communication apparatus described in the foregoing method embodiments of this application may be implemented by using the chip or the integrated circuit.

An embodiment of this application provides a computer-readable storage medium storing a computer program. The computer program includes instructions for performing the foregoing method embodiments.

An embodiment of this application provides a computer program product including instructions. The instructions, when executed on a computer, cause the computer to perform the foregoing method embodiments.

An embodiment of this application provides a communication system. Specifically, the communication system may include a first communication apparatus configured to implement the method shown in FIG. 5 and/or FIG. 9. For details, refer to related descriptions in the foregoing method embodiments. Details are not described herein again. The communication system may include the structure shown in FIG. 1.

A person skilled in the art should understand that embodiments of this application may be provided as a method, a system, or a computer program product. Therefore, this application may use a form of hardware only embodiments, software only embodiments, or embodiments with a combination of software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to embodiments of this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer-readable memory that can instruct the computer or any other programmable data processing device to work in a specific manner, so that the instructions stored in the computer-readable memory generate an artifact that includes an instruction apparatus. The instruction apparatus implements a specific function in one or more processes in the flowcharts and/or in one or more blocks in the block diagrams.

The computer program instructions may alternatively be loaded onto a computer or another programmable data processing device, so that a series of operations and steps are performed on the computer or the another programmable device, so that computer-implemented processing is generated. Therefore, the instructions executed on the computer or the another programmable device provide steps for implementing a specific function in one or more procedures in the flowcharts and/or in one or more blocks in the block diagrams.


**Claims**

1. A method for determining an information bit, comprising:

   determining a first sequence based on a mother code length of a polar code and a length of a to-be-sent bit, wherein the mother code length is a positive integer power of 2, and the first sequence is for adjusting a reliability order of bits in the polar code; and
   determining a position of an information bit in the polar code based on the reliability order and the first sequence.

2. The method according to claim 1, wherein determining the position of the information bit in the polar code based on the reliability order of the bits in the polar code and the first sequence comprises:

   obtaining a first position value of a bit in the polar code;
   selecting an offset value from the first sequence based on the first position value; and
   determining a second position value of the bit in the polar code based on the offset value and the first position value, wherein the second position value is a position index of the information bit in the polar code.

3. The method according to claim 2, wherein the method further comprises:

   selecting an invalid value from the first sequence based on the first position value; and
   determining, based on the invalid value, not to solve the position index of the information bit in the polar code based on the first position value.

4. The method according to claim 2, wherein determining the offset value from the first sequence based on the first position value comprises:

   determining, based on the first position value and a subblock length, a sequence number of a subblock to which the first position value belongs; and
   determining the offset value from a plurality of elements in the first sequence based on the sequence number.

5. The method according to claim 4, wherein the second position value is determined based on the offset value, the first position value, and the subblock length.

6. The method according to any one of claims 1 to 5, further comprising:
   determining a pre-freezing position of the bit of the polar code based on the mother code length and the length of the to-be-sent bit, wherein the pre-freezing position is not used as the position of the information bit.

7. The method according to claim 6, wherein if a code length E of the to-be-sent bit is not exactly divided by N/32, a quantity P of pre-freezing positions meets:

$$P=N-\text{floor}(E/(N/32))*(N/32),$$

or
if E is exactly divided by N/32, the quantity P of pre-freezing positions meets:

$$P=N-E+(N/32),$$

wherein

N represents the mother code length of the polar code, and floor() represents rounding down.

8. The method according to any one of claims 1 to 7, wherein

when 15.5*N/16<E≤N, the first sequence is {0, 0, 0, 0, 0, 0, 0, 0, 0, 0, 0, 0, 0, 0, 0, 0}, wherein N is the mother code length, and E is the length of the to-be-sent bit;
when 14.5*N/16<E≤15.5*N/16, the first sequence is {1, 1, NA, 0, 0, 0, 0, 0, 0, 0, 0, 0, 0, 0, 0, 0}, wherein N is the mother code length, and E is the length of the to-be-sent bit;
when 13.5*N/16<E≤14.5*N/16, the first sequence is {NA, 1, 1, NA, 0, 0, 0, 0, 0, 0, 0, 0, 0, 0, 0, 0}, wherein N is the mother code length, and E is the length of the to-be-sent bit;
when 12.5*N/16<E≤13.5*N/16, the first sequence is {NA, NA, 2, NA, -1, 0, 0, 0, 0, 0, 0, 0, 0, 0, 0, 0}, wherein N is the mother code length, and E is the length of the to-be-sent bit;
when 11.5*N/16<E≤12.5*N/16, the first sequence is {NA, 3, NA, 2, NA, 1, NA, 0, 0, 0, 0, 0, 0, 0, 0, 0}, wherein N is the mother code length, and E is the length of the to-be-sent bit;
when 10.5*N/16<E≤11.5*N/16, the first sequence is {NA, NA, NA, 3, 1, NA, 1, NA, 0, 0, 0, 0, 0, 0, 0, 0}, wherein N is the mother code length, and E is the length of the to-be-sent bit;
when 9.5*N/16<E≤10.5*N/16, the first sequence is {NA, NA, NA, NA, 2, NA, 1, NA, 0, 0, 0, 0, 0, 0, 0, 0}, wherein N is the mother code length, and E is the length of the to-be-sent bit; and
when 8*N/16<E≤9.5*N/16, the first sequence is {NA, NA, NA, 4, NA, NA, NA, NA, 0, 0, 0, 0, 0, 0, 0, 0}, wherein N is the mother code length, and E is the length of the to-be-sent bit.

9. A method for determining an information bit, comprising:

receiving first information, wherein the first information comprises a mother code length of a polar code and a length of a to-be-sent bit, and the mother code length is a positive integer power of 2;
determining a first sequence based on the mother code length of the polar code and the length of the to-be-sent bit, wherein the first sequence is for adjusting a reliability order of bits in the polar code;
determining a position of an information bit in the polar code based on the reliability order and the first sequence; and
decoding, based on the position of the information bit, data encoded by using the polar code.

10. The method according to claim 9, wherein determining the position of the information bit in the polar code based on the reliability order of bits in the polar code and the first sequence comprises:

obtaining a first position value of a bit in the polar code;
selecting an offset value from the first sequence based on the first position value; and
determining a second position value of the bit in the polar code based on the offset value and the first position value, wherein the second position value is a position index of the information bit in the polar code.

11. The method according to claim 10, wherein the method further comprises:

selecting an invalid value from the first sequence based on the first position value; and
determining, based on the invalid value, not to solve the position index of the information bit in the polar code based on the first position value.

12. The method according to claim 10, wherein determining the offset value from the first sequence based on the first position value comprises:

determining, based on the first position value and a subblock length, a sequence number of a subblock to which the first position value belongs; and
determining the offset value from a plurality of elements in the first sequence based on the sequence number.

13. The method according to claim 12, wherein the second position value is determined based on the offset value, the first position value, and the subblock length.

14. The method according to any one of claims 9 to 13, further comprising:
determining a pre-freezing position of the bit of the polar code based on the mother code length and the length of the to-be-sent bit, wherein the pre-freezing position is not used as the position of the information bit.

15. The method according to claim 14, wherein if a code length E of the to-be-sent bit is not exactly divided by N/32, a quantity P of pre-freezing positions meets:

$$P=N-floor(E/(N/32))*(N/32),$$

or
if E is exactly divided by N/32, the quantity P of pre-freezing positions meets:

$$P=N-E+(N/32),$$

wherein
N represents the mother code length of the polar code, and floor() represents rounding down.

16. The method according to any one of claims 9 to 15, wherein

when $15.5*N/16 < E \leq N$, the first sequence is {0, 0, 0, 0, 0, 0, 0, 0, 0, 0, 0, 0, 0, 0, 0, 0}, wherein N is the mother code length, and E is the length of the to-be-sent bit;
when $14.5*N/16 < E \leq 15.5*N/16$, the first sequence is {1, 1, NA, 0, 0, 0, 0, 0, 0, 0, 0, 0, 0, 0, 0}, wherein N is the mother code length, and E is the length of the to-be-sent bit;
when $13.5*N/16 < E \leq 14.5*N/16$, the first sequence is {NA, 1, 1, NA, 0, 0, 0, 0, 0, 0, 0, 0, 0, 0, 0}, wherein N is the mother code length, and E is the length of the to-be-sent bit;
when $12.5*N/16 < E \leq 13.5*N/16$, the first sequence is {NA, NA, 2, NA, -1, 0, 0, 0, 0, 0, 0, 0, 0, 0, 0}, wherein N is the mother code length, and E is the length of the to-be-sent bit;
when $11.5*N/16 < E \leq 12.5*N/16$, the first sequence is {NA, 3, NA, 2, NA, 1, NA, 0, 0, 0, 0, 0, 0, 0, 0}, wherein N is the mother code length, and E is the length of the to-be-sent bit;
when $10.5*N/16 < E \leq 11.5*N/16$, the first sequence is {NA, NA, NA, 3, 1, NA, 1, NA, 0, 0, 0, 0, 0, 0, 0}, wherein N is the mother code length, and E is the length of the to-be-sent bit;
when $9.5*N/16 < E \leq 10.5*N/16$, the first sequence is {NA, NA, NA, NA, 2, NA, 1, NA, 0, 0, 0, 0, 0, 0, 0}, wherein N is the mother code length, and E is the length of the to-be-sent bit; and
when $8*N/16 < E \leq 9.5*N/16$, the first sequence is {NA, NA, NA, 4, NA, NA, NA, NA, 0, 0, 0, 0, 0, 0, 0}, wherein N is the mother code length, and E is the length of the to-be-sent bit.

17. A communication apparatus, comprising: a processor and a memory, wherein the memory is configured to store one or more computer programs, the one or more computer programs comprise computer-executable instructions, and when the communication apparatus is run, the processor executes the one or more computer programs stored in the memory, to enable the communication apparatus to perform the method according to any one of claims 1 to 8, or to enable the communication apparatus to perform the method according to any one of claims 9 to 16.

18. A chip system, wherein the chip system comprises a logic circuit and an input/output interface, wherein

the input/output interface is configured to communicate with another communication apparatus outside the chip system, and the logic circuit is configured to perform the method according to any one of claims 1 to 8; or
the input/output interface is configured to communicate with another communication apparatus outside the chip system, and the logic circuit is configured to perform the method according to any one of claims 9 to 16.

19. A computer-readable storage medium, wherein the computer-readable storage medium is configured to store a computer program, and when the computer program runs on a computer, the computer is enabled to perform the method according to any one of claims 1 to 8, or the computer is enabled to perform the method according to any one of claims 9 to 16.

20. A computer program product, wherein the computer program product comprises a computer program, and when the computer program runs on a computer, the computer is enabled to perform the method according to any one of claims 1 to 8, or the computer is enabled to perform the method according to any one of claims 9 to 16.

21. A communication system, comprising a transmit end and a receive end, wherein the transmit end is configured to perform the method according to any one of claims 1 to 8, and the receive end is configured to perform the method according to any one of claims 9 to 16.

FIG. 1

FIG. 2

FIG. 3A

FIG. 3B

@BLER=0.01 QPSK/AWGN

FIG. 3C

Legend:
- NR E0=289
- NR E0=577
- NR E0=641
- NAT puncturing and based on this application, E0=289
- NAT puncturing and based on this application, E0=577
- NAT puncturing and based on this application, E0=641

Information bit length

SNR

FIG. 4

S101: Determine a first sequence based on a mother code length of a polar code and a length of a to-be-sent bit

S102: Determine a position of an information bit in the polar code based on a reliability order and the first sequence

FIG. 5

K=8, E=20, N=32, a first sequence is {NA, NA, NA, NA, 2, NA, 1, NA, 0, 0, 0, 0, 0, 0, 0, 0}
Subblock length blk=32/16=2

Positions that are not to-be-punctured positions but determined as NA in an adjustment sequence

FIG. 6

An input LLR
average value is L

A code length is N, and a quantity of subblocks is 16
An LLR average value received by an initial channel
side is L

├─ Subblock 0 ─┤  ├─ Subblock 1 ─┤  ├─ Subblock x ─┤  ├─ Subblock y ─┤  ├─ Subblock z ─┤  ├─Subblock 15─┤

After density evolution of log2(16) layers, an input LLR average value of each
subblock is obtained; and the LLR average value of each subblock is the same

Input the subblock x,
where an LLR average
value thereof is A

Input the subblock y,
where an LLR average
value thereof is B

Input the subblock z,
where an LLR average
value thereof is C

├─ Subblock 0 ─┤  ├─ Subblock 1 ─┤  ├─ Subblock x ─┤  ├─ Subblock y ─┤  ├─ Subblock z ─┤  ├─Subblock 15─┤

After density evolution of log2(16) layers, an
LLR average value of each bit is obtained

├─ Subblock 0 ─┤  ├─ Subblock 1 ─┤  ├─ Subblock x ─┤  ├─ Subblock y ─┤  ├─ Subblock z ─┤  ├─Subblock 15─┤

An LLR average value of an
$(x.i)^{th}$ bit position that is in the
subblock x and that is closest to
a decoding side is A.i

An LLR average value of a
$(y.i)^{th}$ bit position that is in the
subblock y and that is closest to
a decoding side is B.i

An LLR average value of a $(z.i)^{th}$
bit position that is in the
subblock z and that is closest to
a decoding side is C.i

Sort A.0, A.1, A.2, ..., B.0, B.1, B.2, ..., C.0, C.1, C.2, ...to obtain
a sequence Q, and obtain a relative position relationship of x.0,
x.1, x.2, ..., y.0, y.1, y.2, ..., y.0, y.1, ..., and y.2 in a sequence Q'

y.63                  z.126

Sequence Q          x.0    x.1    x.2    y.0                      x.127    z.31    y.127    z.127

FIG. 7

Corresponding to an original position of y.i, and if
not replaced by another sub-block, set to NA

Sequence Q

y.2    y.63    z.126

y.0    y.1    y.0    y.127    z.31    y.127    z.127

FIG. 8

Transmit
end

Receive end

S201: Determine a position of an
information bit in a polar code

S202: Set a value of a position of a
frozen bit to 0, and map a to-be-sent bit
to the position of the information bit

S203: Modulated polar code →

S204: Demodulate a received signal

S205: Perform rate dematching
based on a to-be-punctured position

S206: Obtain, based on the position
of the information bit in the polar
code, information mapped through
the information bit

FIG. 9

Communication
apparatus 1000

Processing unit 1010

Communication unit
1020

FIG. 10

1100

1110

Output
interface

1120

Processor

1130

Memory

FIG. 11

1201

1200

Input interface
circuit

1202

Logic circuit

1203

Output interface
circuit

FIG. 12

## INTERNATIONAL SEARCH REPORT

| International application No. |
|---|
| **PCT/CN2022/137015** |

### A. CLASSIFICATION OF SUBJECT MATTER

H04L1/00(2006.01)i

According to International Patent Classification (IPC) or to both national classification and IPC

### B. FIELDS SEARCHED

Minimum documentation searched (classification system followed by classification symbols)

IPC: H04L H04W

Documentation searched other than minimum documentation to the extent that such documents are included in the fields searched

Electronic data base consulted during the international search (name of data base and, where practicable, search terms used)

CNABS; CNTXT; VEN; USTXT; WOTXT; ENTXT; CNKI; 3GPP: 长度, 打孔, 冻结, 极化码, 可靠度, 母码, 排列, 排序, 顺序, 偏移, 取整, 位置, 序列, length, punch+, frozen, polar, reliability, mother code, order, offset, floor, position, sequence.

### C. DOCUMENTS CONSIDERED TO BE RELEVANT

| Category* | Citation of document, with indication, where appropriate, of the relevant passages | Relevant to claim No. |
|---|---|---|
| X | CN 111200476 A (HUAWEI TECHNOLOGIES CO., LTD.) 26 May 2020 (2020-05-26) description, paragraphs 60-113, and figures 5-7 | 1, 6, 9, 14, 17-21 |
| A | CN 110247730 A (HUAWEI TECHNOLOGIES CO., LTD.) 17 September 2019 (2019-09-17) entire document | 1-21 |
| A | CN 107819545 A (HUAWEI TECHNOLOGIES CO., LTD.) 20 March 2018 (2018-03-20) entire document | 1-21 |
| A | CN 109286468 A (ZTE CORP.) 29 January 2019 (2019-01-29) entire document | 1-21 |
| A | CN 114070330 A (HUAWEI TECHNOLOGIES CO., LTD.) 18 February 2022 (2022-02-18) entire document | 1-21 |
| A | WO 2022117061 A1 (HUAWEI TECHNOLOGIES CO., LTD.) 09 June 2022 (2022-06-09) entire document | 1-21 |
| A | NOKIA NETWORKS. "Corrections for alignment between charging specifications" *3GPP TSG-SA5 Meeting #96 S5-144422*, 22 August 2014 (2014-08-22), entire document | 1-21 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **20 July 2023** | **05 August 2023** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2022/137015**

| Patent document cited in search report | | | Publication date (day/month/year) | Patent family member(s) | | | Publication date (day/month/year) |
|---|---|---|---|---|---|---|---|
| CN | 111200476 | A | 26 May 2020 | WO | 2020098461 | A1 | 22 May 2020 |
| | | | | US | 2023098837 | A1 | 30 March 2023 |
| | | | | EP | 3873010 | A1 | 01 September 2021 |
| | | | | EP | 3873010 | A4 | 29 December 2021 |
| | | | | US | 2021328599 | A1 | 21 October 2021 |
| | | | | US | 11502704 | B2 | 15 November 2022 |
| | | | | VN | 80206 | A | 25 August 2021 |
| | | | | IN | 202117023282 | A | 01 October 2021 |
| | | | | CN | 111200476 | B | 14 December 2021 |
| | | | | CN | 114172617 | A | 11 March 2022 |
| CN | 110247730 | A | 17 September 2019 | WO | 2019170113 | A1 | 12 September 2019 |
| | | | | CN | 110247730 | B | 23 October 2020 |
| CN | 107819545 | A | 20 March 2018 | WO | 2018045849 | A1 | 15 March 2018 |
| | | | | US | 2019207720 | A1 | 04 July 2019 |
| | | | | US | 10574401 | B2 | 25 February 2020 |
| | | | | EP | 3499761 | A1 | 19 June 2019 |
| | | | | EP | 3499761 | A4 | 21 August 2019 |
| | | | | IN | 201937010022 | A | 26 April 2019 |
| | | | | CN | 107819545 | B | 14 February 2020 |
| | | | | US | 10574401 | B2 | 25 February 2020 |
| CN | 109286468 | A | 29 January 2019 | CN | 109286468 | B | 09 August 2022 |
| CN | 114070330 | A | 18 February 2022 | | None | | |
| WO | 2022117061 | A1 | 09 June 2022 | CN | 114614943 | A | 10 June 2022 |

Form PCT/ISA/210 (patent family annex) (July 2022)